# EUROPEAN PATENT SPECIFICATION

(11) **EP 3 961 901 B1**
(45) Date of publication and mention of the grant of the patent: **24.05.2023**
(21) Application number: 20848189.5
(22) Date of filing: 29.07.2020
(51) Int. Cl.: H02M 7/217, H02M 1/42, H01L 29/861, H03K 17/74, H03K 17/30

(54) **ACTIVE DIODE CIRCUIT AND ALTERNATING CURRENT/DIRECT CURRENT POWER SUPPLY CONVERSION CIRCUIT**
AKTIVE DIODENSCHALTUNG UND WECHSELSTROM/GLEICHSTROM-STROMWANDLUNGSSCHALTUNG
CIRCUIT À DIODE ACTIVE ET CIRCUIT DE CONVERSION D'ALIMENTATION EN PUISSANCE À COURANT ALTERNATIF/COURANT CONTINU

(30) Priority: 29.07.2019 CN 201910688008
(43) Date of publication of application: 02.03.2022
(73) Proprietor: Shenzhen Huntkey Electric Co., Ltd., Shenzen, Guangdong 518000 (CN)
(72) Inventor: DUAN, Weiyin, Shenzhen, Guangdong 518000 (CN)
(74) Representative: Miller Sturt Kenyon
(86) International application number: PCT/CN2020/105555
(87) International publication number: WO 2021/018204

(56) References cited:
- EP-A1- 3 961 901
- WO-A1-2019/003421
- CN-A- 101 056 068
- CN-A- 101 431 297
- CN-A- 101 431 297
- CN-A- 105 191 136
- CN-A- 105 264 670
- CN-A- 110 445 402
- CN-B- 113 300 578
- JP-A- 2007 110 869
- JP-A- 2007 110 869
- TW-B- 261 961
- US-A1- 2007 058 402
- US-A1- 2016 105 172
- US-A1- 2019 006 954
- US-A1- 2021 119 626
- US-B2- 9 419 608

## Description

### TECHNICAL FIELD

The present application relates to the field of electronic technology, and particularly to an active diode circuit and an AC-DC power conversion circuit.

### BACKGROUND

The commonly used bridge rectifying circuit is composed of diodes, and the circuit rectifies alternating current (AC) into direct current (DC). The diode rectifier bridge has the disadvantages of low efficiency and increased temperature. In the design of power adapters and chargers, the diode rectifier bridge is the device with the highest temperature, which can cause the plastic shell to dissolve or soften.

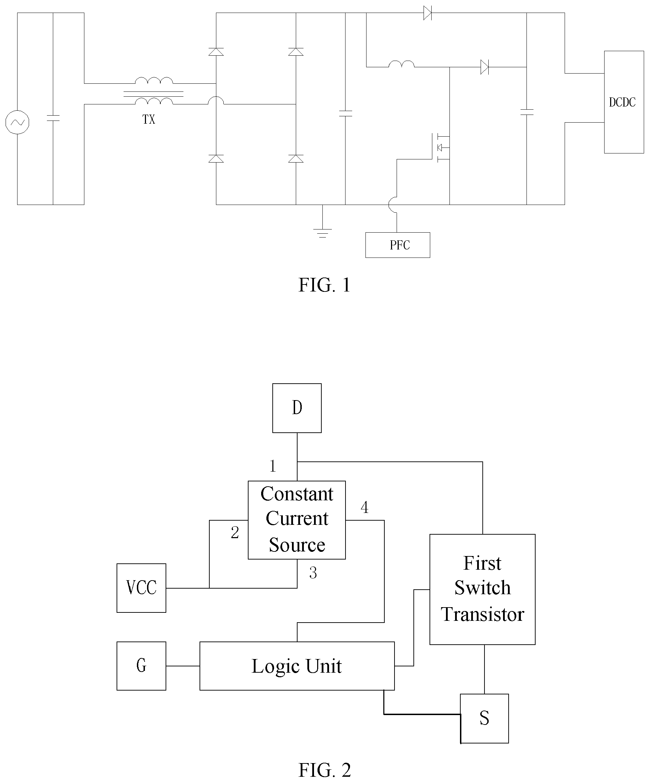

PFC (Power Factor Correction) circuit is usually set at the input terminal of the switching power supply to improve the power factor of the power supply, eliminate high-order harmonics, and reduce the loss of the electric grid. With improved energy efficiency standards for power converters, many schemes of bridgeless PFC have been adopted in industry. As shown in FIG. 1, a diode rectifier bridge is provided at the input terminal, and the power factor correction circuit is composed of a Boost circuit. Active switching devices, such as MOSFET and GaN, are used in the rectifying circuit. The number of PFC inductors increases, and the use of dual inductors increases the system volume. In the control and protection circuit, more discrete devices are used.

US20190006954A1 has mentioned a synchronous bridge rectifier, which includes a plurality of synchronously switched elements and a plurality of controller circuits, one for each of the synchronously switched elements. The synchronously switched elements may be field-effect transistors. Each controller circuit is configured to sense voltage across the corresponding synchronously switched element to control opening and closing of the synchronously switched element so as to rectify the alternating current input signal to form a direct current output signal.

### TECHNICAL PROBLEMS

In view of the above, the embodiments of the present application provide an active diode circuit and an AC/DC power conversion circuit, so as to solve the problems of the diode temperature rise of the rectifier bridge and the complex structure of the PFC circuit.

### TECHNICAL SOLUTIONS

A first aspect of the embodiments of the present application provides an active diode circuit, including a power interface, a drain interface, a control interface, a source interface, a logic unit, a constant current source, and a first switch transistor;
the constant current source is provided with a first terminal, a second terminal, a third terminal and a fourth terminal, the first terminal being connected to the drain interface of the active diode circuit, the second terminal and the third terminal both being connected to the power interface, and the fourth terminal being connected to the logic unit; and the constant current source is configured to provide a constant current for the power interface when a voltage input from the drain interface of the active diode circuit charges an external energy storage capacitor through the power interface;
the logic unit is provided with a first input terminal, a second input terminal and an output terminal, the first input terminal being connected to the fourth terminal of the constant current source, the second input terminal being connected to the control interface, and the output terminal being connected to a gate electrode of the first switch transistor; and the logic unit is configured to:
   monitor whether a parasitic body diode of the first switch transistor is in conduction state, that is, whether a voltage difference between a source electrode and a drain electrode of the first switch transistor is greater than a conducting voltage of the body diode,
   receive a PWM signal input from the control interface as a control signal for the first switch transistor, if the body diode is in non-conduction state;
   shield the PWM signal input from the control interface and output an electric level signal to control the first switch transistor to be in conduction state, if the body diode is in conduction state;
   the drain electrode of the first switch transistor is connected to the drain interface of the active diode circuit, and the source electrode of the first switch transistor is connected to the source interface of the active diode circuit; and
   the constant current source includes a first diode and a second switch transistor; and the second switch transistor is provided as a depletion-type MOS transistor or JFET transistor, wherein a drain electrode of the second switch transistor is provided as the first terminal of the constant current source, a source electrode of the second switch transistor is connected to an anode of the first diode and provided as the fourth terminal of the constant current source, and a gate electrode of the second switch transistor is provided as the second terminal of the constant current source; and a cathode of the first diode is provided as the third terminal of the constant current source.

A second aspect of the embodiments of the present application provides an AC / DC power conversion circuit, including an AC voltage positive input terminal, an AC voltage negative input terminal, a DC voltage output terminal, a reference ground terminal, a PFC controller, a first capacitor, a second capacitor, a third capacitor, a fourth capacitor, a common-differential mode inductor, a third diode, a fourth diode, and two above-said active diode circuits;
the PFC controller is configured to output a PFC control signal on the basis of a sampling voltage of the DC voltage output terminal and a sampling current of the common-differential mode inductor;
the first capacitor is connected in series between the AC voltage positive input terminal and the AC voltage negative input terminal;
the second capacitor is connected in series between the DC voltage output terminal and the reference ground terminal;
the common-differential mode inductor is provided with a primary winding and a secondary winding, a positive terminal of the primary winding is connected to the AC voltage positive input terminal, a negative terminal of the primary winding is connected to an anode of the third diode, a positive terminal of the secondary winding is connected to the AC voltage negative input terminal, a negative terminal of the secondary winding is connected to an anode of the fourth diode, a differential mode inductor of the common-differential mode inductor is configured for energy storage of a PFC circuit, and a common mode inductor of the common-differential mode inductor is configured to eliminate common-mode noise;
a drain interface of a first active diode circuit is connected to the anode of the third diode, a source interface of the first active diode circuit is connected to the reference ground terminal, a power interface of the first active diode circuit is connected to the reference ground terminal through the third capacitor, and a control interface of the first active diode circuit is connected to an output terminal of the PFC controller;
a drain interface of a second active diode circuit is connected to the anode of the fourth diode, a source interface of the second active diode circuit is connected to the reference ground terminal, a power interface of the second active diode circuit is connected to the reference ground terminal through the fourth capacitor, and a control interface of the second active diode circuit is connected to the output terminal of the PFC controller;
a cathode of the third diode and a cathode of the fourth diode are connected to the DC voltage output terminal.

A third aspect of the embodiments of the present application provides an AC / DC power conversion circuit, including an AC voltage positive input terminal, an AC voltage negative input terminal, a DC voltage output terminal, a reference ground terminal, a first capacitor, a second capacitor, a third capacitor, a fourth capacitor, a common-differential mode inductor, a third diode, a fourth diode, and two above-said active diode circuits;
the first capacitor is connected between the AC voltage positive input terminal and the AC voltage negative input terminal;
the second capacitor is connected between the DC voltage output terminal and the reference ground terminal;
the common-differential mode inductor is provided with a primary winding and a secondary winding; a positive terminal of the primary winding is connected to the AC voltage positive input terminal, a negative terminal of the primary winding is connected to an anode of the third diode; a positive terminal of the secondary winding is connected to the AC voltage negative input terminal, and a negative terminal of the secondary winding is connected to an anode of the fourth diode;
an input interface of a first active diode circuit is connected to the anode of the third diode, a ground interface of the first active diode circuit is connected to the reference ground terminal, a power interface of the first active diode circuit is connected to the reference ground terminal through the third capacitor, and a control interface of the first active diode circuit is connected to the reference ground terminal;
an input interface of a second active diode circuit is connected to the anode of the fourth diode, a ground interface of the second active diode circuit is connected to the reference ground terminal, a power interface of the second active diode circuit is connected to the reference ground terminal through the fourth capacitor, and a control interface of the second active diode circuit is connected to the reference ground terminal;
a cathode of the third diode and a cathode of the fourth diode are connected to the DC voltage output terminal.

### BENEFICIAL EFFECTS

The beneficial effects of the present application:
The present application designs an active diode circuit, by detecting the on/off state (conduction/non-conduction state) of the body diode of the first switch transistor, the first switch transistor is controlled to be in conduction state or non-conducive to realize unidirectional conduction, so as to rectify the alternating current. Compared with diode, the switch transistor has the characteristics of low conduction loss, which can effectively reduce the conduction loss and the overall temperature rise of the circuit in specific application circuits.

The present application combines the inductor involved in the circuit for realizing the PFC function in the prior art with the common-differential mode inductor at the input terminal, at the same time, the switching device and diode for the PFC are incorporated into the rectifying circuit, i.e. the active diode circuit. Both the function of rectification and the function of receiving PFC control can be realized. The present application reduces discrete-component part count, simplifies the controller of the PFC circuit, improves the power density of the AC/DC power conversion circuit, and improves the efficiency of the rectifying circuit and the power correction circuit.

### BRIEF DESCRIPTION OF THE DRAWINGS

In order to more clearly explain the technical solutions in the embodiments of the present application, the drawings needed in the description of the embodiments or the prior art will be briefly introduced hereafter. Obviously, the drawings in the following description are only some embodiments of the present application, for those of ordinary skill in the art, other drawings may also be obtained based on these drawings without paying creative labor.
FIG. 1 is a circuit diagram of an AC-DC power conversion circuit in the prior art;
FIG. 2 is a schematic block diagram of an active diode circuit according to an embodiment of the present application;
FIG. 3 is a circuit diagram of an active diode circuit according to an embodiment of the present application;
FIG. 4 is an operating timing diagram of an active diode circuit according to an embodiment of the present application;
FIG. 5 is a circuit diagram of an AC-DC power conversion circuit according to an embodiment of the present application;
FIG. 6 is an operating timing diagram of an AC-DC power conversion circuit according to an embodiment of the present application;
FIG. 7 is a circuit diagram of an AC-DC power conversion circuit according to another embodiment of the present application;
FIG. 8 is a circuit diagram of a protection circuit according to an embodiment of the present application;
FIG. 9 is an operating timing diagram of a start-up surge protection of an AC-DC power conversion circuit according to an embodiment of the present application;
FIG. 10 is a circuit diagram of an AC-DC power conversion circuit according to yet another embodiment of the present application;
FIG. 11 is an operating timing diagram of a start-up surge and overvoltage protection of an AC-DC power conversion circuit according to an embodiment of the present application;
FIG. 12 is a circuit diagram of an AC-DC power conversion circuit according to still another embodiment of the present application.

In the figures: 100-constant current source; 200-logic unit.

### DETAILED DESCRIPTION

In order to enable those of ordinary skill in the art to better understand the solutions of the present application, the technical solutions in the embodiments of the present application will be clearly described below in combination with the accompanying drawings in the embodiments of the present application. Obviously, the described embodiments are just some embodiments of the present application, not all embodiments.

The term "comprising/including" and any variations thereof in the specification and claims of the present application are intended to cover a non-exclusive inclusion. For example, a process, method, system, product, or device that includes a series of steps or units is not limited to the listed steps or units, but may optionally include unlisted steps or units, or may optionally include other steps or units inherent in this process, method, system, product or device.

As shown in FIGS 2-3, the active diode circuit includes a power interface VCC, a drain interface D of the active diode circuit, a control interface G, a source interface S of the active diode circuit, a logic unit 200, a constant current source 100, and the first switch transistor Q1. The first terminal of the constant current source 100 is connected to the drain interface D of the active diode circuit, the second terminal and the third terminal of the constant current source 100 are both connected to the power interface VCC, and the fourth terminal is connected to the logic unit 200. The constant current source 100 is configured to provide a constant current for the power interface VCC when the voltage input from the drain interface D of the active diode circuit charges the power interface VCC. The first input terminal of the logic unit 200 is connected to the fourth terminal VD1 of the constant current source 100, the second input terminal of the logic unit 200 is connected to the control interface G, and the output terminal of the logic unit 200 is connected to the gate of the first switch transistor Q1. The logic unit 200 is configured to monitor whether the parasitic body diode of the first switch transistor Q1 is in conduction state, that is, the whether the voltage difference between the source electrode and the drain electrode of the first switch transistor Q1 is greater than the conducting voltage of the body diode, if not, the body diode is in non-conduction state, the PWM (Pulse Width Modulation) signal input from the control interface G is received and used as the control signal for the first switch transistor Q1; if it is, the body diode is in conduction state, the PWM signal input from the control interface G is shielded, and an electric level signal is output, the electric level signal is high or low, and the first switch transistor Q1 is controlled to be in conduction state. The drain electrode of the first switch transistor Q1 is connected to the drain interface D of the active diode circuit, and the source electrode of the first switch transistor Q1 is connected to the source interface S of the active diode circuit.

When the constant current source 100 is in conduction state, the voltage at the sampling point VD1 of the logic unit 200 is approximately equal to the drain voltage of the first switch transistor Q1, and the source electrode of the first switch transistor Q1 is grounded, so the voltage collected by the logic unit 200 is the voltage difference between the drain voltage and the source voltage of the first switch transistor Q1. The constant current source 100 can be connected with an external energy storage capacitor through the power interface VCC. The logic unit 200 collects the drain voltage of the first switch transistor Q1, receives the PWM signal through the control interface G, and outputs control signal for the first switch transistor Q1, such that the conduction or non-conduction between the drain electrode and source electrode of the first switch transistor Q1 can be realized according to control signal for the first switch transistor Q1. When the active diode circuit is operating, the drain electrode of the first switch transistor Q1 is connected with an external AC power through the drain interface D of the active diode circuit. Through the conduction or non-conduction between the drain electrode and source electrode of the first switch transistor Q1, the alternating current can be rectified. Compared with the diode, the MOS switch transistor used in this circuit has the characteristics of low conducting resistance, which can effectively reduce the temperature rise in specific application circuits.

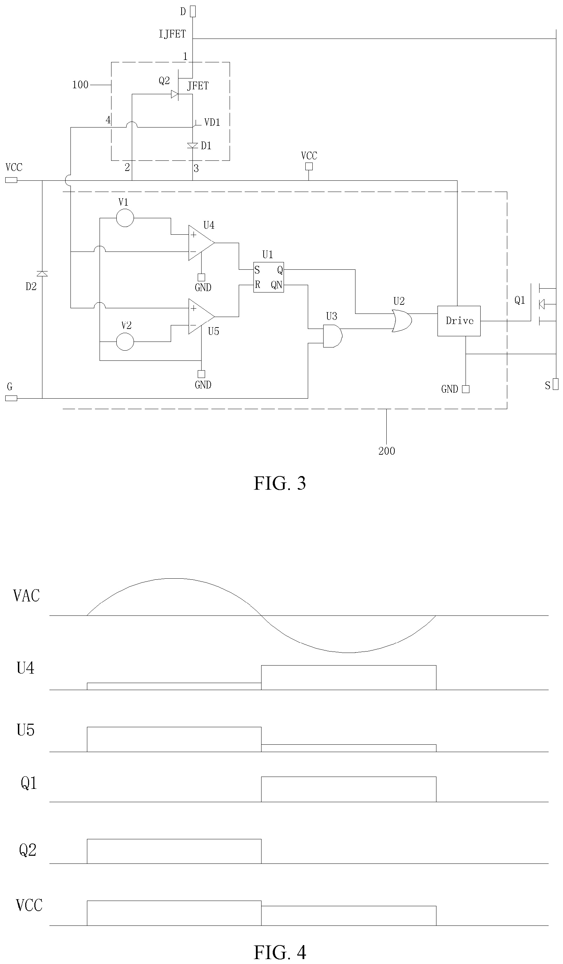

As shown in FIG. 3, the logic unit 200 includes a first comparator U4, a second comparator U5, a first RS flip-flop U1, and an OR gate U2, and the source interface of the active diode circuit is grounded.

The first comparator U4 is configured to receive the drain voltage of the first switch transistor Q1 through the constant current source 100, and compare the drain voltage of the first switch transistor Q1 with a first reference voltage to output a first signal. The first reference voltage can be provided by the first reference circuit V1, and the first reference circuit V1 can be correspondingly designed according to actual requirements to output the required first reference voltage.

The second comparator U5 is configured to receive the drain voltage of the first switch transistor Q1 through the constant current source 100, and compare the drain voltage of the first switch transistor Q1 with a second reference voltage to output a second signal. The second reference voltage can be provided by the second reference circuit V2, and the second reference circuit V2 can be correspondingly designed according to actual requirements to output the required second reference voltage.

The first RS flip-flop U1 is configured to output and latch a third signal on the basis of the first signal and the second signal.

The OR gate U2 is configured to perform OR logic on the third signal and the PWM signal, and output the control signal for the first switch transistor Q1. If the third signal is at a high electric level, the PWM signal is shielded at this time, the control signal for the first switch transistor Q1 is at a high electric level, and the first switch transistor Q1 is controlled to be in conduction state; if the third signal is at a low electric level, the PWM signal is provided as the control signal for the first switch transistor Q1 at this time, and the first switch transistor Q1 is controlled to be in conduction or non-conduction state on the basis of the PWM signal.

In an embodiment, the logic unit 200 further includes a first AND gate U3. The first AND gate U3 is configured to perform AND logic on the NOT-signal of the third signal and the PWM signal, and output a fourth signal. The OR gate U2 is configured to perform OR logic on the third signal and the fourth signal, and output the control signal for the first switch transistor Q1.

When the third signal is at a high electric level, the control signal for the first switch transistor Q1 output through the OR gate U2 is at a high electric level, at this time, the gate electrode of the first switch transistor Q1 receives the high electric level, and the source electrode and drain electrode of the first switch transistor Q1 are in conduction state. When the third signal is at a low electric level, AND logic is performed on the NOT-signal of the third signal and the PWM signal, thus the output fourth signal is the PWM signal, after performing OR logic on the fourth signal and the third signal, the control signal of the switch transistor Q1, that is the PWM signal, is output, and at this time the PWM signal is provided as the control signal for the first switch transistor Q1.

In an embodiment, the logic unit 200 further includes a first driver Drive. The first driver Drive, connected in series between the gate electrode of the first switch transistor Q1 and the OR gate U2, is configured to add a drive for the control signal for the first switch transistor Q1, so as to ensure that the control signal for the first switch transistor Q1, after passing through the first driver Drive, can drive the first switch transistor Q1 to be in conduction or non-conduction state.

In an embodiment, the active diode circuit further includes a first diode D1. The anode of the first diode D1 is respectively connected to the third terminal of the constant current source 100 and the first input terminal of the logic unit 200. The cathode of the first diode D1 is connected to the power interface VCC.

The constant current source 100 is connected to an external power supply or energy storage capacitor, and charges the power interface VCC of the active diode circuit through the third interface. When charging, the first diode D1 is in the conduction state and can charge the power interface VCC. When not charging, the first diode D1 can prevent the current from back flowing, thereby ensuring the sufficient energy of the power interface VCC.

In an embodiment, the constant current source 100 includes a first diode D1 and a second switch transistor Q2. The second switch transistor Q2 is provided as a depletion-type MOS transistor or JFET transistor. The drain electrode of the second switch transistor Q2 is provided as the first terminal of the constant current source 100, the source electrode of the second switch transistor Q2 is connected to the anode of the first diode D1, and a gate electrode of the second switch transistor Q2 is provided as the second terminal of the constant current source 100. The cathode of the first diode D1 is provided as the third terminal of the constant current source 100.

Either a depletion-type MOS transistor or a depletion-type JFET transistor can be used for the constant current source 100 to provide a stable current for charging the power interface VCC of the active diode circuit.

In an embodiment, the active diode circuit further includes a second diode D2, the anode of the second diode D2 is connected to the control interface G, and the cathode of the second diode D2 is connected to the power interface VCC.

The control interface G in the active diode circuit is connected to a PFC controller. While inputting the control signal through the control interface G, the PFC controller can also charge the power interface VCC to solve the problem of insufficient energy of the power interface VCC.

In an embodiment, the timing of the active diode circuit is shown as FIG. 4, at this time, the PWM signal received by the control interface G of the active diode circuit is at a low electric level, that is, the active diode is only used as a diode:
(1) When the AC voltage VAC input from the drain interface D of the active diode circuit is in a positive half cycle, the constant current source 100 provides a constant current to charge the external capacitor connected to the power interface VCC, and the voltage of the power interface VCC is a high electric level. At this time VD1>0, the parasitic body diode is in non-conduction state, the first comparator U4 outputs a low electric level, the second comparator U5 outputs a high electric level, the Q interface of the first RS flip-flop U1 outputs a low electric level, the QN interface outputs a high electric level, the first AND gate U3 outputs a low electric level, the OR gate U2 outputs a low electric level, and the low electric level output by the OR gate U2 passes through the first driver Drive as a control signal for the first switch transistor Q1 to control the first switch transistor Q 1 to be in non-conduction state, that is, the drain interface D of the active diode circuit and the source interface S of the active diode circuit are not conducting.
(2) When the AC voltage VAC input from the drain interface D of the active diode circuit is in a negative half cycle, the constant current source 100 will no longer charge the power interface VCC, since the power interface VCC is connected with the external capacitor, the capacitor discharges at this time, and the voltage of the power interface VCC is also a high electric level, but slightly lower than the voltage when VAC is in the positive half cycle. At this time, VD1<0, VD1 continues to decrease until the parasitic body diode is in conduction state, the first comparator U4 outputs a high electric level, the second comparator U5 outputs a low electric level, the Q interface of the first RS flip-flop U1 outputs a high electric level, the QN interface outputs a low electric level, the first AND gate U3 outputs a low electric level, the OR gate U2 outputs a high electric level, and the high electric level output by the OR gate U2 passes through the first driver Drive as a control signal for the first switch transistor Q1 to control the first switch transistor Q1 to be in conduction state.

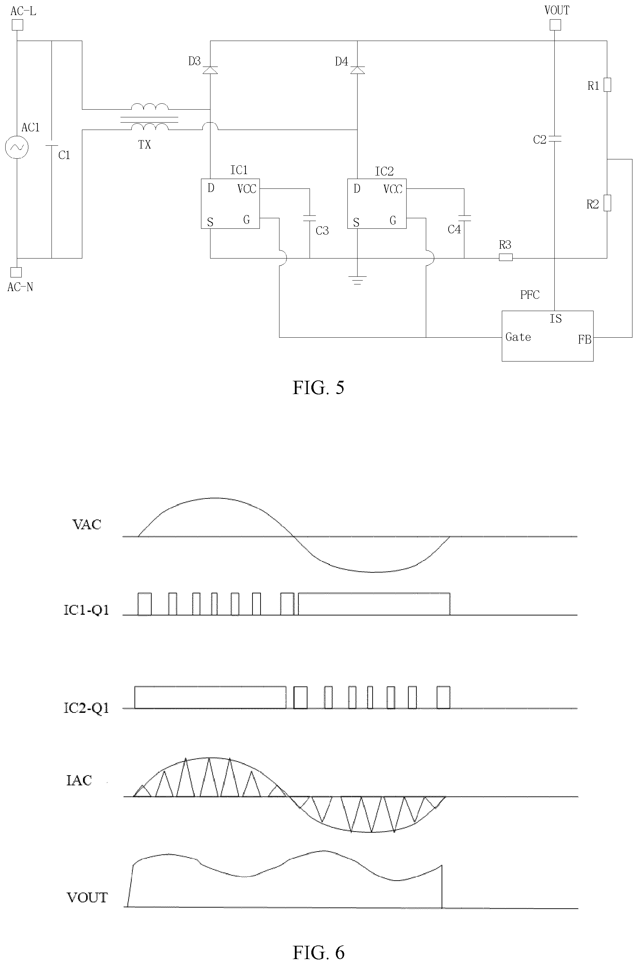

As shown in FIG. 5, the present application discloses an AC-DC power conversion circuit, which includes an AC voltage positive input terminal, an AC voltage negative input terminal, a DC voltage output terminal, a reference ground terminal, a PFC controller, a first capacitor C1, a first capacitor C1, a second capacitor C2, a third capacitor C3, a fourth capacitor C4, a common-differential mode inductor, a third diode D3, a fourth diode D4, and two above-said active diode circuits. The PFC controller is configured to output a PFC control signal on the basis of the sampling voltage of the DC voltage output terminal and the sampling current of the common-differential mode inductor. The first capacitor is connected in series between the AC voltage positive input terminal and the AC voltage negative input terminal. The second capacitor C2 is connected in series between the DC voltage output terminal and the reference ground terminal. The positive terminal of the primary winding of the common-differential mode inductor is connected to the AC voltage positive input terminal, the negative terminal of the primary winding of the common-differential mode inductor is connected to the anode of the third diode D3, the positive terminal of the secondary winding of the common-differential mode inductor is connected to the AC voltage negative input terminal, the negative terminal of the secondary winding of the common-differential mode inductor is connected to the anode of the fourth diode D4, the differential mode inductor of the common-differential mode inductor is configured for energy storage of the PFC circuit, and the common mode inductor of the common-differential mode inductor is configured to eliminate common-mode noise. The drain interface D of a first active diode circuit IC1 is connected to the anode of the third diode D3, the source interface S of the first active diode circuit IC1 is connected to the reference ground terminal, the power interface VCC of the first active diode circuit IC1 is connected to the reference ground terminal through the third capacitor C3, and the control interface G of the first active diode circuit IC1 is connected to the output terminal of the PFC controller. The drain interface D of a second active diode circuit IC2 is connected to the anode of the fourth diode D4, the source interface S of the second active diode circuit IC2 is connected to the reference ground terminal, the power interface VCC of the second active diode circuit IC2 is connected to the reference ground terminal through the fourth capacitor C4, and the control interface G of the second active diode circuit IC2 is connected to the output terminal of the PFC controller. The cathode of the third diode D3 and the cathode of the fourth diode D4 are connected to the DC voltage output terminal respectively.

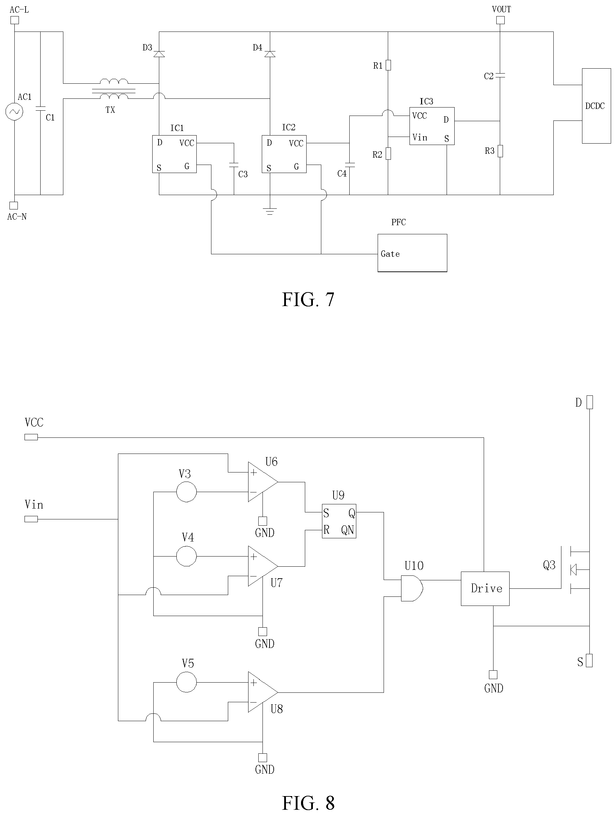

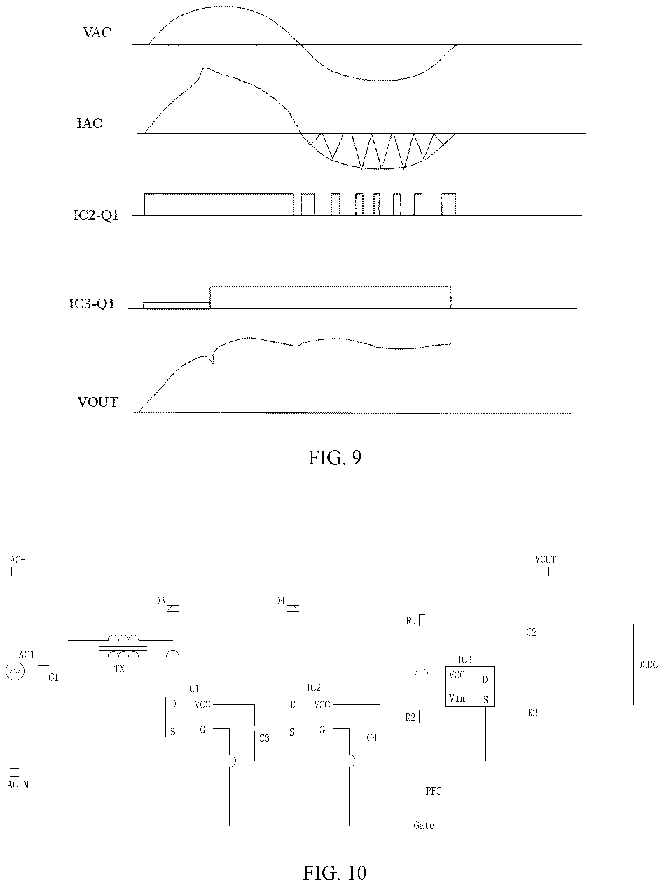

The PFC controller can be a variety of controllers that can realize PFC control in the prior art. It includes two input terminals, one terminal receives the sampling current of the DC voltage output terminal (the IS terminal in FIG. 5), and the other terminal receives the sampling voltage of the DC voltage output terminal (the FB terminal in FIG. 5), the output terminal is the PWM signal (the Gate terminal in FIG. 5). The connections of the PFC controller and its terminals in FIG. 7 and FIG. 10 are the same as that in FIG. 5. In order to simplify the drawing, two input terminals and the connections there between are omitted.

In this solution, the traditional rectifier bridge composed of four diodes is no longer used, but two above-said active diode circuits are used, which can realize the function of converting alternating current into direct current. The active diode circuit has the characteristics of low conduction loss, and reduces the temperature rise of the circuit.

At the same time, the AC-DC power conversion circuit in this solution combines the PFC inductor in the prior art with the common-differential mode inductor TX at the input terminal, and at the same time the switching devices and diodes for PFC are incorporated into the rectifying circuit, i.e. the active diode circuit. Both the function of rectification and the function of receiving PFC control can be realized. The present application reduces separation devices, simplifies the controller of the PFC circuit, and improves the power density of the AC-DC power conversion circuit.

In an embodiment, the timing of the active diode circuit is shown as FIG. 6, at this time the control interface G of the active diode circuit receives the PWM signal. In the figure, IC1-Q1 is the driving signal waveform of the switch transistor Q1 of the first active diode circuit IC1, IC2-Q1 is the driving signal waveform of the first switch transistor Q1 of the second active diode circuit IC2:
(1) When the VAC is in a positive half cycle, the first active diode circuit IC1 is controlled by the PFC controller, and the first switch transistor Q1 is in a frequent on-off state. The first switch transistor Q1 of IC1 in the PFC circuit is equivalent to that shown in FIG. 1, and two differential mode inductors of the common-differential mode inductor are short circuited. The second active diode circuit IC2 is not controlled by the PFC controller, IC2-Q1 is at a high electric level, and the first switch transistor Q1 of IC2 is in conduction state, the first switch transistor Q1 of IC2 plays a rectifying role.
(2) When VAC is in a negative half cycle, the first active diode circuit IC1 is not controlled by the PFC controller, IC1-Q1 is at a high electric level, the first switch transistor Q1 of IC1 is in conduction state, and the first switch transistor Q1 of IC1 plays a rectifying role. The second active diode circuit IC2 is controlled by the PFC controller, IC2-Q1 is a PWM signal, the first switch transistor Q1 of IC2 is in a frequent on-off state, and the first switch transistor Q1 of IC2 in the PFC circuit is equivalent to the switch transistor in FIG. 1.

Assuming that the PFC controller is working in critical mode, the triangular wave in IAC is the current waveform in the primary coil and secondary coil of the common-differential mode inductor. Of course, by increasing the leakage inductance of TX1, they can also work in continuous mode. VOUT is the output voltage waveform.

As shown in FIG. 7, the AC-DC power conversion circuit also includes a protection circuit IC3, a first resistor R1, a second resistor R2, and a third resistor R3. The first resistor R1 and the second resistor R2 are connected in series between the DC voltage output terminal and the reference ground terminals, and they are configured to divide voltage output from the DC voltage output terminal to obtain the second sampling voltage. The third resistor R3 is connected between the second capacitor C2 and the reference ground terminal. The protection circuit IC3 includes a supply interface VCC, an input interface Vin, the drain interface D of the protection circuit, the source interface S of the protection circuit, and the switch transistor Q3 of the protection circuit. The supply interface VCC of the protection circuit IC3 is connected to the power interface VCC of the first active diode circuit IC1 or the power interface VCC of the second active diode circuit IC2, the input interface Vin of the protection circuit IC3 is configured to receive the second sampling voltage, the drain interface D of the protection circuit IC3 is connected to the common terminal of the second capacitor C2 and the third resistor R3, and the source interface S of the protection circuit IC3 is connected to the reference ground terminal. The drain electrode of the switch transistor Q3 of the protection circuit IC3 is connected to the drain interface D of the protection circuit IC3, and the source electrode of the switch transistor Q3 of the protection circuit IC3 is connected to the source interface S of the protection circuit IC3. The protection circuit IC3 is configured to detect the second sampling voltage. When the second sampling voltage is less than the fourth reference voltage or the second sampling voltage is greater than the fifth reference voltage, the switch transistor Q3 of the protection circuit IC3 is controlled to be in non-conduction state; when the second sampling voltage is greater than the third reference voltage and less than the fifth reference voltage, the switch transistor Q3 of the protection circuit is controlled to be in conduction state, such that the third resistor R3 is short-circuited by the switch transistor Q3 of the protection circuit IC3 .

The first resistor R1 and the second resistor R2 form a sampling circuit. The third resistor R3 and the second capacitor C2 are connected in series between the DC voltage output terminal and the reference ground. The third resistor R3 plays the role of current limiting. The protection circuit IC3 collects the voltage at the common terminal of the first resistor R1 and the second resistor R2, and controls the conduction or non-conduction of the switch transistor Q3 of the protection circuit IC3 on the basis of the collected voltage. When the switch transistor Q3 of the protection circuit IC3 is in conduction state, the third resistor R3 is short-circuited , when the switch transistor Q3 of the protection circuit IC3 is in non-conduction state, the third resistor R3 and the second capacitor C2 are connected in series to limit the current, thereby playing the role of protecting the subsequent circuit and the second capacitor C2.

As shown in FIG. 8, the protection circuit IC3 includes a third comparator U6, a fourth comparator U7, a fifth comparator U8, a second RS flip-flop U9, and a second AND gate U10. The third comparator U6 is configured to compare the second sampling voltage with the fourth reference voltage, and output a second comparison signal. The fourth comparator U7 is configured to compare the second sampling voltage with the third reference voltage, and output a third comparison signal. The fifth comparator U8 is configured to compare the second sampling voltage with the fifth reference voltage, and output a first comparison signal. The second RS flip-flop U9 is configured to receive the second comparison signal and the third comparison signal, and output a latch signal. The second AND gate U10 is configured to perform AND logic on the latch signal and the first comparison signal, and output a control signal of the switch transistor Q3 of the protection circuit IC3. The switch transistor Q3 of the protection circuit IC3 is configured to be in conduction or non-conduction state on the basis of the control signal of the switch transistor Q3 of the protection circuit IC3.

By collecting the voltage at the common terminal of the first resistor R1 and the second resistor R2, and combining the fifth reference voltage, the fourth reference voltage and the third reference voltage, the drain electrode and source electrode of the switch transistor Q3 of the protection circuit IC3 is controlled to be in conduction or non-conduction state, thereby realizing whether the third resistor R3 can be connected to the output loop.

In an embodiment, the fourth reference voltage is less than the third reference voltage, and the third reference voltage is less than the fifth reference voltage. The fifth reference voltage, the fourth reference voltage, and the third reference voltage can be provided by correspondingly designing the fifth reference circuit V5, the third reference circuit V3, and the fourth reference circuit V4 according to actual requirements, so as to meet the logic requirements of the circuit.

As shown in FIG. 7, the AC-DC power conversion circuit also includes a DCDC conversion circuit configured for converting a higher DC voltage output from the DC voltage output terminal into a lower DC voltage. The DCDC conversion circuit includes a supply interface and a ground interface. The supply interface of the DCDC conversion circuit is connected to the DC voltage output terminal, and the ground interface of the DCDC conversion circuit is connected to the reference ground terminal.

This circuit is provided with a start-up surge protection function. As shown in FIG. 9, it is an operating timing diagram of the start-up surge protection of the AC-DC power conversion circuit, where VAC is the input AC voltage, IAC is the input current waveform, IC2-Q1 is the driving signal waveform of the first switch transistor Q1 in the second active diode circuit IC2, IC3-Q1 is the driving signal waveform of the switch transistor in the protection circuit IC3, and VOUT is the output waveform:
(1) When starting up, there is surge current, the output voltage of the DC voltage output terminal is almost zero, the second sampling voltage received by the protection circuit IC3 is less than the fourth reference voltage, and the second RS flip-flop U9 outputs a low electric level, which passes through the driver Drive to control the switch transistor Q3 of the protection circuit IC3 to be in non-conduction state. At this time, the third resistor R3 and the second capacitor C2 are connected in series in the circuit, and the third resistor R3 limits the charging current of the second capacitor C2, thereby protecting the subsequent circuit.
(2) When charging to a certain stage, the surge current is greatly reduced at this time, the second sampling voltage received by the protection circuit IC3 is between the fifth reference voltage and the fourth reference voltage, and the second RS trigger U9 outputs a high electric level, which passes through the driver Drive to control the switch transistor Q3 of the drive control protection circuit IC3 to be in conduction state, the third resistor R3 is short-circuited, and the start-up surge finishes current limiting.

As shown in FIG. 10, the AC-DC power conversion circuit also includes a DCDC conversion circuit for converting a higher DC voltage output from the DC voltage output terminal into a lower DC voltage. The DCDC conversion circuit includes a supply interface and a ground interface. The supply interface of the DCDC conversion circuit is connected to the DC voltage output terminal, and the ground interface of the DCDC conversion circuit is connected to the common terminal of the second capacitor C2 and the third resistor R3.

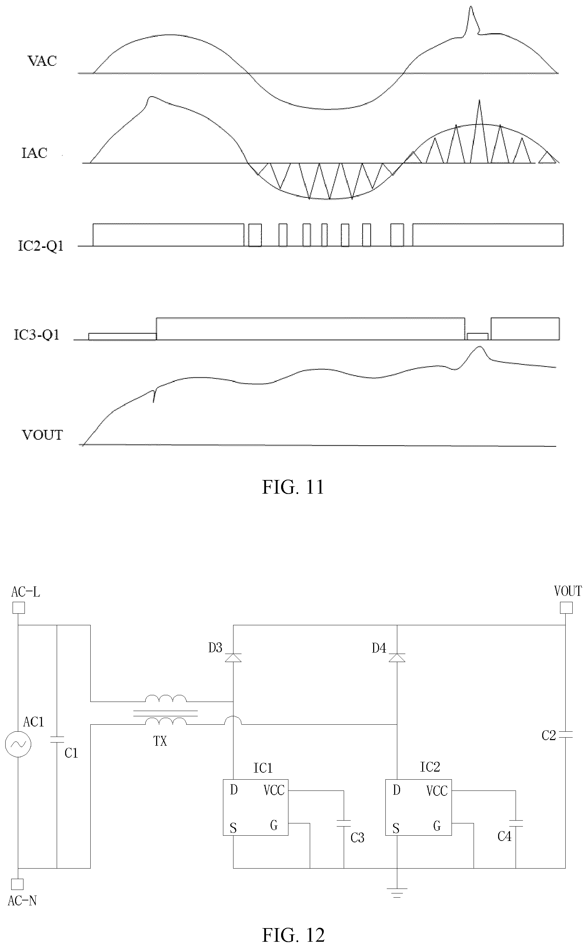

This circuit is provided with the functions of start-up surge protection and overvoltage protection. As shown in FIG. 11, it is the operating timing diagram of the start-up surge and overvoltage protection of the AC-DC power conversion circuit, where VAC is the input AC voltage, IAC is the input current waveform, IC2-Q1 is the driving signal waveform of the first switch transistor Q1 in the second active diode circuit IC2, IC3-Q1 is the driving signal waveform of the switch transistor in the protection circuit IC3, and VOUT is the output waveform:
(1) When starting up, there is surge current, the output voltage of the DC voltage output terminal is almost zero, the second sampling voltage received by the protection circuit IC3 is less than the fourth reference voltage, and the second RS flip-flop U9 outputs a low electric level, which passes through the driver Drive to control the switch transistor Q3 of the protection circuit IC3 to be in non-conduction state. At this time, the third resistor R3 and the second capacitor C2 are connected in series in the circuit, and the third resistor R3 limits the charging current of the second capacitor C2, thereby protecting the subsequent circuit.
(2) When charging to a certain stage, the surge current is greatly reduced at this time, the second sampling voltage received by the protection circuit IC3 is between the fifth reference voltage and the fourth reference voltage, and the second RS trigger U9 outputs a high electric level, which passes through the driver Drive to control the switch transistor Q3 of the drive control protection circuit IC3 to be in conduction state, the third resistor R3 is short-circuited, and the start-up surge finishes current limiting.
(3) When the output voltage of the DC voltage output terminal continues to rise and an overvoltage pulse appears, the second sampling voltage received by the protection circuit IC3 is greater than the fifth reference voltage, the fifth comparator U8 outputs a low electric level, and the second AND gate U10 outputs a low electric level, which passes through the driver Drive to control the switch transistor Q3 of the drive control protection circuit IC3 to be in non-conduction state. The third resistor R3 is connected in series between the reference ground terminal (input ground) and the ground terminal of the DCDC conversion circuit (the ground terminal of the DCDC conversion circuit is the output ground), which plays a role of limiting the amplitude of the overvoltage pulse and protecting the subsequent circuit.
(4) When the overvoltage pulse ends, the second sampling voltage received by the protection circuit IC3 at this time is between the third reference voltage and the fifth reference voltage, returning to step (2) to continue execution, and the overvoltage protection ends.

As shown in FIG. 12, the present application discloses another AC-DC power conversion circuit, including an AC voltage positive input terminal, an AC voltage negative input terminal, a DC voltage output terminal, a reference ground terminal, a first capacitor C1, a second capacitor C2, a third capacitor C3, a fourth capacitor C4, a common-differential mode inductor, a third diode D3, a fourth diode D4, and two above-said active diode circuits. The first capacitor C1 is connected between the AC voltage positive input terminal and the AC voltage negative input terminal. The second capacitor C2 is connected between the DC voltage output terminal and the reference ground terminal. The positive terminal of the primary winding of the common-differential mode inductor is connected to the AC voltage positive input terminal, and the negative terminal of the primary winding of the common-differential mode inductor is connected to the anode of the third diode D3. The positive terminal of the secondary winding of the common-differential mode inductor is connected to the AC voltage negative input terminal, and the negative terminal of the secondary winding of the common-differential mode inductor is connected to the anode of the fourth diode D4. The input interface Vin of the first active diode circuit IC1 is connected to the anode of the third diode D3, the ground interface of the first active diode circuit IC1 is connected to the reference ground terminal, the power interface VCC of the first active diode circuit IC1is connected to the reference ground terminal through the third capacitor C3, and the control interface G of the first active diode circuit IC1 is connected to the reference ground terminal. The input interface Vin of the second active diode circuit IC2 is connected to the anode of the fourth diode D4, the ground interface of the second active diode circuit IC2 is connected to the reference ground terminal, the power interface VCC of the second active diode circuit IC2 is connected to the reference ground terminal through the fourth capacitor C4, and the control interface G of the second active diode circuit IC2 is connected to the reference ground terminal. The cathode of the third diode D3 and the cathode of the fourth diode D4 are connected to the DC voltage output terminal.

In this solution, the control interfaces G of the first active diode circuit IC1 and the second active diode circuit IC2 are both connected to the reference ground terminal. When the input AC voltage VAC is in a positive half cycle, the first switch transistor Q1 in the first active diode circuit IC1 is in a non-conducing state, and the first switch transistor Q1 in the second active diode circuit IC2 is in conduction state. When the input AC voltage VAC is in a negative half cycle, the first switch transistor Q1 in the first active diode circuit IC1 is in a conducing state, and the first switch transistor Q1 in the second active diode circuit IC2 is in non-conduction state. The first active diode circuit IC1 and the second active diode circuit IC2 cooperate with the first diode D1 and the second diode D2 to form a rectifier bridge, which realizes the function of rectifying the input alternating current.

In this solution, the traditional rectifier bridge composed of four diodes is no longer used, but two above-said active diode circuits are used, which can realize the function of converting alternating current into direct current. The active diode circuit has the characteristics of low conduction loss, and reduces the temperature rise of the circuit.

The above embodiments are only used to explain the technical solutions of the present application, but not to limit the present application. Although the present application has been described in detail with reference to the foregoing embodiments, those of ordinary skill in the art should understand that the technical solutions recorded in the foregoing embodiments can still be modified, or some of the technical features thereof can be equivalently replaced.

## Claims

1. An active diode circuit, the active diode circuit comprises a power interface (VCC), a drain interface (D), a control interface (G), a source interface (S), a logic unit (200), a constant current source (100), and a first switch transistor (Q1); wherein
the constant current source (100) is provided with a first terminal, a second terminal, a third terminal and a fourth terminal, the first terminal being connected to the drain interface (D) of the active diode circuit, the second terminal and the third terminal both being connected to the power interface (VCC), and the fourth terminal being connected to the logic unit (200); and the constant current source (100) is configured to provide a constant current when a voltage input from the drain interface (D) of the active diode circuit charges an external energy storage capacitor through the power interface (VCC);
the logic unit (200) is provided with a first input terminal, a second input terminal and an output terminal, the first input terminal being connected to the fourth terminal of the constant current source (100), the second input terminal being connected to the control interface (G), and the output terminal being connected to a gate electrode of the first switch transistor (Q1); and the logic unit (200) is configured to:
monitor whether a parasitic body diode of the first switch transistor (Q1) is in conduction state, that is, whether a voltage difference between a source electrode and a drain electrode of the first switch transistor (Q1) is greater than a conducting voltage of the body diode,
receive a PWM signal input from the control interface (G) as a control signal for the first switch transistor (Q1), if the body diode is in non-conduction state; and
shield the PWM signal input from the control interface (G) and output an electric level signal to control the first switch transistor (Q1) to be in conduction state, if the body diode is in conduction state; and
the drain electrode of the first switch transistor (Q1) is connected to the drain interface of the active diode circuit, and the source electrode of the first switch transistor (Q1) is connected to the source interface (S) of the active diode circuit,
wherein
the constant current source (100) comprises a first diode (D1) and a second switch transistor (Q2); and the second switch transistor (Q2) is provided as a depletion-type MOS transistor or JFET transistor, wherein a drain electrode of the second switch transistor (Q2) is provided as the first terminal of the constant current source (100), a source electrode of the second switch transistor (Q2) is connected to an anode of the first diode (D1) and provided as the fourth terminal of the constant current source (100), and a gate electrode of the second switch transistor (Q2) is provided as the second terminal of the constant current source (100); and a cathode of the first diode (D1) is provided as the third terminal of the constant current source (100).

2. The active diode circuit according to claim 1, **characterized in that**, the logic unit (200) comprises a first comparator (U4), a second comparator (U5), a first RS flip-flop (U1), and a OR gate (U2), and the source interface (S) of the active diode circuit is connected to a ground potential; wherein
the first comparator (U4) is configured to receive a drain voltage of the first switch transistor (Q1) through the fourth terminal of the constant current source (100), and compare the drain voltage of the first switch transistor (Q1) with a first reference voltage to output a first signal;
the second comparator (U5) is configured to receive the drain voltage of the first switch transistor (Q1) through the fourth terminal of the constant current source (100), and compare the drain voltage of the first switch transistor (Q1) with a second reference voltage to output a second signal;
the first RS flip-flop (U1) is configured to output and latch a third signal on the basis of the first signal and the second signal; and
the OR gate (U2) is configured to perform OR logic on the third signal and the PWM signal, and output the control signal for the first switch transistor (Q1).

3. The active diode circuit according to claim 3, **characterized in that**, the logic unit (200) further comprises a first AND gate (U3); wherein
the first AND gate (U3) is configured to perform AND logic on a NOT-signal of the third signal and the PWM signal, and output a fourth signal; and
the OR gate (U2) is configured to perform OR logic on the third signal and the fourth signal, and output the control signal for the first switch transistor (Q1).

4. The active diode circuit according to claim 1, **characterized in that**, the active diode circuit further comprises a second diode (D2), wherein an anode of the second diode is connected to the control interface (G), and a cathode of the second diode is connected to the power interface (VCC).

5. An AC-DC power conversion circuit, **characterized in that**, the AC-DC power conversion circuit comprises an AC voltage positive input terminal, an AC voltage negative input terminal, a DC voltage output terminal, a reference ground terminal, a PFC controller, a first capacitor (C1), a second capacitor (C2), a third capacitor (C3), a fourth capacitor (C4), a common-differential mode inductor, a third diode (D3), a fourth diode (D4), and two active diode circuits (IC1, IC2) according to any one of claims 1-4; wherein
the PFC controller is configured to output a PFC control signal on the basis of a sampling voltage of the DC voltage output terminal and a sampling current of the common-differential mode inductor;
the first capacitor (C1) is connected in series between the AC voltage positive input terminal and the AC voltage negative input terminal;
the second capacitor (C2) is connected in series between the DC voltage output terminal and the reference ground terminal;
the common-differential mode inductor is provided with a primary winding and a secondary winding, a positive terminal of the primary winding is connected to the AC voltage positive input terminal, a negative terminal of the primary winding is connected to an anode of the third diode (D3), a positive terminal of the secondary winding is connected to the AC voltage negative input terminal, a negative terminal of the secondary winding is connected to an anode of the fourth diode (D4), a differential mode inductor of the common-differential mode inductor is configured for energy storage of a PFC circuit, and a common mode inductor of the common-differential mode inductor is configured to eliminate common-mode noise;
a drain interface of a first active diode circuit (IC1) is connected to the anode of the third diode, a source interface of the first active diode circuit (IC1) is connected to the reference ground terminal, a power interface (VCC) of the first active diode circuit (IC 1) is connected to the reference ground terminal through the third capacitor (C3), and a control interface of the first active diode circuit (IC 1) is connected to an output terminal of the PFC controller;
a drain interface of a second active diode circuit (IC2) is connected to the anode of the fourth diode, a source interface of the second active diode circuit (IC2) is connected to the reference ground terminal, a power interface (VCC) of the second active diode circuit (IC2) is connected to the reference ground terminal through the fourth capacitor (C4), and a control interface of the second active diode circuit (IC2) is connected to the output terminal of the PFC controller; and
a cathode of the third diode (D3) and a cathode of the fourth diode (D4) are connected to the DC voltage output terminal.

6. The AC-DC power conversion circuit according to claim 5, **characterized in that**, the AC-DC power conversion circuit further comprises a protection circuit (IC3), a first resistor (R1), a second resistor (R2), and a third resistor (R3); wherein
the first resistor (R1) and the second resistor (R2), connected in series between the DC voltage output terminal and the reference ground terminal, are configured to divide voltage output from the DC voltage output terminal to obtain a second sampling voltage;
the third resistor (R3) is connected between the second capacitor (C2) and the reference ground terminal;
the protection circuit (IC3) comprises a supply interface (VCC), an input interface (Vin), a drain interface (D), a source interface (S), and a switch transistor (Q3); the supply interface (VCC) of the protection circuit (IC3) is connected to the power interface (VCC) of the first active diode circuit (IC1) or the power interface (VCC) of the second active diode circuit (IC2), the input interface (Vin) of the protection circuit (IC3) is configured to receive the second sampling voltage, the drain interface (D) of the protection circuit (IC3) is connected to a common terminal of the second capacitor (C2) and the third resistor (R3), and the source interface (S) of the protection circuit (IC3) is connected to the reference ground terminal;
a drain electrode of the switch transistor (Q3) of the protection circuit (IC3) is connected to the drain interface (D) of the protection circuit (IC3), and a source electrode of the switch transistor (Q3) of the protection circuit (IC3) is connected to the source interface (S) of the protection circuit (IC3); and
the protection circuit (IC3) is configured to detect the second sampling voltage, when the second sampling voltage is less than a fourth reference voltage or the second sampling voltage is greater than a fifth reference voltage, the switch transistor (Q3) of the protection circuit (IC3) is controlled to be in non-conduction state; and when the second sampling voltage is greater than a third reference voltage and less than the fifth reference voltage, the switch transistor (Q3) of the protection circuit (IC3) is controlled to be in conduction state.

7. The AC-DC power conversion circuit according to claim 6, **characterized in that**, the protection circuit (IC3) further comprises a third comparator (U6), a fourth comparator (U7), a fifth comparator (U8), a second RS flip-flop (U9), and a second AND gate (U10); wherein
the third comparator (U6) is configured to compare the second sampling voltage with the fourth reference voltage, and output a second comparison signal;
the fourth comparator (U7) is configured to compare the second sampling voltage with the third reference voltage, and output a third comparison signal;
the fifth comparator (U8) is configured to compare the second sampling voltage with the fifth reference voltage, and output a first comparison signal;
the second RS flip-flop (U9) is configured to receive the second comparison signal and the third comparison signal, and output a latch signal;
the second AND gate (U10) is configured to perform AND logic on the latch signal and the first comparison signal, and output a control signal of the switch transistor (Q3) of the protection circuit (IC3); and
the switch transistor of the protection circuit (IC3) is configured to be in conduction or non-conduction state on the basis of the control signal of the switch transistor (Q3) of the protection circuit (IC3).

8. The AC-DC power conversion circuit according to claim 6, **characterized in that**, the AC-DC power conversion circuit further comprises a DCDC conversion circuit configured for converting a higher DC voltage output from the DC voltage output terminal into a lower DC voltage, wherein the DCDC conversion circuit comprises a supply interface and a ground interface, the supply interface of the DCDC conversion circuit is connected to the DC voltage output terminal, and the ground interface of the DCDC conversion circuit is connected to the reference ground terminal.

9. The AC-DC power conversion circuit according to claim 6, **characterized in that**, the AC-DC power conversion circuit further comprises a DCDC conversion circuit configured for converting a higher DC voltage output from the DC voltage output terminal into a lower DC voltage, wherein the DCDC conversion circuit comprises a supply interface and a ground interface, the supply interface of the DCDC conversion circuit is connected to the DC voltage output terminal, and the ground interface of the DCDC conversion circuit is connected to the common terminal of the second capacitor (C2) and the third resistor (R3).

10. An AC-DC power conversion circuit, **characterized in that**, the AC-DC power conversion circuit comprises an AC voltage positive input terminal, an AC voltage negative input terminal, a DC voltage output terminal, a reference ground terminal, a first capacitor (C1), a second capacitor (C2), a third capacitor (C3), a fourth capacitor (C4), a common-differential mode inductor, a third diode (D3), a fourth diode (D4), and two active diode circuits (IC1, IC2) according to any one of claims 1-4; wherein
the first capacitor (C1) is connected between the AC voltage positive input terminal and the AC voltage negative input terminal;
the second capacitor (C2) is connected between the DC voltage output terminal and the reference ground terminal;
the common-differential mode inductor is provided with a primary winding and a secondary winding; a positive terminal of the primary winding is connected to the AC voltage positive input terminal, a negative terminal of the primary winding is connected to an anode of the third diode (D); a positive terminal of the secondary winding is connected to the AC voltage negative input terminal, and a negative terminal of the secondary winding is connected to an anode of the fourth diode (D4);
an input interface of a first active diode circuit (IC1) is connected to the anode of the third diode (D3), a ground interface of the first active diode circuit (IC1) is connected to the reference ground terminal, a power interface (VCC) of the first active diode circuit (IC 1) is connected to the reference ground terminal through the third capacitor (C3), and a control interface (G) of the first active diode circuit (IC1) is connected to the reference ground terminal;
an input interface of a second active diode circuit (IC2) is connected to the anode of the fourth diode (D4), a ground interface of the second active diode circuit (IC2) is connected to the reference ground terminal, a power interface (VCC) of the second active diode circuit (IC2) is connected to the reference ground terminal through the fourth capacitor (C3), and a control interface (G) of the second active diode circuit (IC2) is connected to the reference ground terminal; and
a cathode of the third diode (D3) and a cathode of the fourth diode (D4) are connected to the DC voltage output terminal.

## Patentansprüche

1. Aktive Diodenschaltung, wobei die aktive Diodenschaltung eine Leistungsschnittstelle (VCC), eine Drainschnittstelle (D), eine Steuerschnittstelle (G), eine Sourceschnittstelle (S), eine Logikeinheit (200), eine Konstantstromquelle (100) und einen ersten Schalttransistor (Q1) umfasst, wobei
die Konstantstromquelle (100) mit einem ersten Anschluss, einem zweiten Anschluss, einem dritten Anschluss und einem vierten Anschluss versehen ist, der erste Anschluss an die Drainschnittstelle (D) der aktiven Diodenschaltung angeschlossen ist, der zweite Anschluss und der dritte Anschluss beide an die Leistungsschnittstelle (VCC) angeschlossen sind und der vierte Anschluss an die Logikeinheit (200) angeschlossen ist, und die Konstantstromquelle (100) ausgelegt ist zum Liefern eines konstanten Stroms, wenn eine von der Drainschnittstelle (D) der aktiven Diodenschaltung eingegebene Spannung einen externen Energiespeicherkondensator durch die Leistungsschnittstelle (VCC) lädt;
die Logikeinheit (200) mit einem ersten Eingangsanschluss, einem zweiten Eingangsanschluss und einem Ausgangsanschluss versehen ist, der erste Eingangsanschluss an den vierten Anschluss der Konstantstromquelle (100) angeschlossen ist, der zweite Eingangsanschluss an die Steuerschnittstelle (G) angeschlossen ist und der Ausgangsanschluss an eine Gateelektrode des ersten Schalttransistors (Q1) angeschlossen ist; und die Logikeinheit (200) ausgelegt ist zum:
Überwachen, ob eine parasitäre Körperdiode des ersten Schalttransistors (Q1) sich in einem Leitungszustand befindet, das heißt, ob eine Spannungsdifferenz zwischen einer Sourceelektrode und einer Drainelektrode des ersten Schalttransistors (Q1) größer ist als eine leitende Spannung der Körperdiode,
Empfangen eines von der Steuerschnittstelle (G) eingegebenen PWM-Signals als ein Steuersignal für den ersten Schalttransistor (Q1), falls sich die Körperdiode in einem nichtleitenden Zustand befindet; und
Abschirmen des von der Steuerschnittstelle (G) eingegebenen PWM-Signals und Ausgeben eines Strompegelsignals, um zu steuern, dass sich der erste Schalttransistor (Q1) in einem Leitungszustand befindet, falls sich die Körperdiode in einem Leitungszustand befindet; und
die Drainelektrode des ersten Schalttransistors (Q1) an die Drainschnittstelle der aktiven Diodenschaltung angeschlossen ist und die Sourceelektrode des ersten Schalttransistors (Q1) an die Sourceschnittstelle (S) der aktiven Diodenschaltung angeschlossen ist,
wobei
die Konstantstromquelle (100) eine erste Diode (D1) und einen zweiten Schalttransistor (Q2) umfasst und der zweite Schalttransistor (Q2) als ein MOS-Transistor vom Verarmungstyp oder ein JFET-Transistor vorgesehen ist, wobei eine Drainelektrode des zweiten Schalttransistors (Q2) als der erste Anschluss der Konstantstromquelle (100) vorgesehen ist, eine Sourceelektrode des zweiten Schalttransistors (Q2) an eine Anode der ersten Diode (D1) angeschlossen ist und als der vierte Anschluss der Konstantstromquelle (100) vorgesehen ist und eine Gateelektrode des zweiten Schalttransistors (Q2) als der zweite Anschluss der Konstantstromquelle (100) vorgesehen ist, und eine Kathode der ersten Diode (D1) als der dritte Anschluss der Konstantstromquelle (100) vorgesehen ist.

2. Aktive Diodenschaltung nach Anspruch 1, **dadurch gekennzeichnet, dass** die Logikeinheit (200) einen ersten Vergleicher (U4), einen zweiten Vergleicher (U5), einen ersten RS-Flipflop (U1) und ein OR-Gatter (U2) umfasst und die Sourceschnittstelle (S) der aktiven Diodenschaltung an ein Massepotential angeschlossen ist, wobei
der erste Vergleicher (U4) ausgelegt ist zum Empfangen einer Drainspannung des ersten Schalttransistors (Q1) durch den vierten Anschluss der Konstantstromquelle (100) und Vergleichen der Drainspannung des ersten Schalttransistors (Q1) mit einer ersten Referenzspannung, um ein erstes Signal auszugeben;
der zweite Vergleicher (U5) ausgelegt ist zum Empfangen der Drainspannung des ersten Schalttransistors (Q1) durch den vierten Anschluss der Konstantstromquelle (100) und Vergleichen der Drainspannung des ersten Schalttransistors (Q1) mit einer zweiten Referenzspannung, um ein zweites Signal auszugeben;
der erste RS-Flipflop (U1) ausgelegt ist zum Ausgeben und Zwischenspeichern eines dritten Signals auf Basis des ersten Signals und des zweiten Signals; und
das OR-Gatter (U2) ausgelegt ist zum Durchführen einer OR-Logik an dem dritten Signal und dem PWM-Signal und Ausgeben des Steuersignals für den ersten Schalttransistor (Q1).

3. Aktive Diodenschaltung nach Anspruch 3, **dadurch gekennzeichnet, dass** die Logikeinheit (200) weiter ein erstes AND-Gatter (U3) umfasst, wobei
das erste AND-Gatter (U3) ausgelegt ist zum Durchführen einer AND-Logik an einem NOT-Signal des dritten Signals und des PWM-Signals und Ausgeben eines vierten Signals; und
das OR-Gatter (U2) ausgelegt ist zum Durchführen einer OR-Logik an dem dritten Signal und dem vierten Signal und Ausgeben des Steuersignals für den ersten Schalttransistor (Q1).

4. Aktive Diodenschaltung nach Anspruch 1, **dadurch gekennzeichnet, dass** die aktive Diodenschaltung weiter eine zweite Diode (D2) umfasst, wobei eine Anode der zweiten Diode an die Steuerschnittstelle (G) angeschlossen ist und eine Kathode der zweiten Diode an die Leistungsschnittstelle (VCC) angeschlossen ist.

5. AC-DC-Leistungsumrichtschaltung, **dadurch gekennzeichnet, dass** die AC-DC-Leistungsumrichtschaltung einen positiven AC-Spannungseingangsanschluss, einen negativen AC-Spannungseingangsanschluss, einen DC-Spannungsausgangsanschluss, einen Referenzmasseanschluss, einen PFC-Controller, einen ersten Kondensator (C1), einen zweiten Kondensator (C2), einen dritten Kondensator (C3), einen vierten Kondensator (C4), einen Common-Differential-Mode-Induktor, eine dritte Diode (D3), eine vierte Diode (D4) und zwei aktive Diodenschaltungen (IC1, IC2) nach einem der Ansprüche 1-4 umfasst; wobei
der PFC-Controller ausgelegt ist zum Ausgeben eines PFC-Steuersignals auf Basis einer Abtastspannung des DC-Spannungsausgangsanschlusses und eines Abtaststroms des Common-Differential-Mode-Induktors;
der erste Kondensator (C1) in Reihe zwischen den positiven AC-Spannungseingangsanschluss und den negativen AC-Spannungseingangsanschluss geschaltet ist;
der zweite Kondensator (C2) in Reihe zwischen den DC-Spannungsausgangsanschluss und den Referenzmasseanschluss geschaltet ist;
der Common-Differential-Mode-Induktor mit einer Primärwicklung und einer Sekundärwicklung versehen ist, ein positiver Anschluss der Primärwicklung an den positiven AC-Spannungseingangsanschluss angeschlossen ist, ein negativer Anschluss der Primärwicklung an eine Anode der dritten Diode (D3) angeschlossen ist, ein positiver Anschluss der Sekundärwicklung an den negativen AC-Spannungseingangsanschluss angeschlossen ist, ein negativer Anschluss der Sekundärwicklung an eine Anode der vierten Diode (D4) angeschlossen ist, ein Differential-Mode-Induktor des Common-Differential-Mode-Induktors ausgelegt ist zur Energiespeicherung einer PFC-Schaltung und ein Common-Mode-Induktor des Common-Differential-Mode-Induktors ausgelegt ist zum Eliminieren von Common-Mode-Rauschen;
eine Drainschnittstelle einer ersten aktiven Diodenschaltung (IC1) an die Anode der dritten Diode angeschlossen ist, eine Sourceschnittstelle der ersten aktiven Diodenschaltung (IC1) an den Referenzmasseanschluss angeschlossen ist, eine Leistungsschnittstelle (VCC) der ersten aktiven Diodenschaltung (IC1) durch den dritten Kondensator (C3) an den Referenzmasseanschluss angeschlossen ist und eine Steuerschnittstelle der ersten aktiven Diodenschaltung (IC1) an einen Ausgangsanschluss des PFC-Controllers angeschlossen ist;
eine Drainschnittstelle einer zweiten aktiven Diodenschaltung (IC2) an die Anode der vierten Diode angeschlossen ist, eine Sourceschnittstelle der zweiten aktiven Diodenschaltung (IC2) an den Referenzmasseanschluss angeschlossen ist, eine Leistungsschnittstelle (VCC) der zweiten aktiven Diodenschaltung (IC2) durch den vierten Kondensator (C4) an den Referenzmasseanschluss angeschlossen ist und eine Steuerschnittstelle der zweiten aktiven Diodenschaltung (IC2) an den Ausgangsanschluss des PFC-Controllers angeschlossen ist; und
eine Kathode der dritten Diode (D3) und eine Kathode der vierten Diode (D4) an den DC-Spannungsausgangsanschluss angeschlossen sind.

6. AC-DC-Leistungsumrichtschaltung nach Anspruch 5, **dadurch gekennzeichnet, dass** die AC-DC-Leistungsumrichtschaltung weiter eine Schutzschaltung (IC3), einen ersten Widerstand (R1), einen zweiten Widerstand (R2) und einen dritten Widerstand (R3) umfasst; wobei
der erste Widerstand (R1) und der zweite Widerstand (R2), in Reihe zwischen den DC-Spannungsausgangsanschluss und den Referenzmasseanschluss geschaltet, ausgelegt sind zum Aufteilen einer von dem DC-Spannungsausgangsanschluss ausgegebenen Spannung, um eine zweite Abtastspannung zu erhalten;
ein dritter Widerstand (R3) zwischen den zweiten Kondensator (C2) und den Referenzmasseanschluss geschaltet ist;
die Schutzschaltung (IC3) eine Versorgungsschnittstelle (VCC) und eine Eingangsschnittstelle (Vin), eine Drainschnittstelle (D), eine Sourceschnittstelle (S) und einen Schalttransistor (Q3) umfasst, die Versorgungsschnittstelle (VCC) der Schutzschaltung (IC3) an die Leistungsschnittstelle (VCC) der ersten aktiven Diodenschaltung (IC1) oder die Leistungsschnittstelle (VCC) der zweiten aktiven Diodenschaltung (IC2) angeschlossen ist, die Eingangsschnittstelle (Vin) der Schutzschaltung (IC3) ausgelegt ist zum Empfangen der zweiten Abtastspannung, die Drainschnittstelle (D) der Schutzschaltung (IC3) an einen gemeinsamen Anschluss des zweiten Kondensators (C2) und des dritten Widerstands (R3) angeschlossen ist und die Sourceschnittstelle (S) der Schutzschaltung (IC3) an den Referenzmasseanschluss angeschlossen ist;
eine Drainelektrode des Schalttransistors (Q3) der Schutzschaltung (IC3) an die Drainschnittstelle (D) der Schutzschaltung (IC3) angeschlossen ist und eine Sourceelektrode des Schalttransistors (Q3) der Schutzschaltung (IC3) an die Sourceschnittstelle (S) der Schutzschaltung (IC3) angeschlossen ist; und
die Schutzschaltung (IC3) ausgelegt ist zum Detektieren der zweiten Abtastspannung, wenn die zweite Abtastspannung unter einer vierten Referenzspannung liegt oder die zweite Abtastspannung über einer fünften Referenzspannung liegt, der Schalttransistor (Q3) der Schutzschaltung (IC3) so gesteuert wird, dass er sich in einem Nichtleitungszustand befindet, und wenn die zweite Abtastspannung größer ist als eine dritte Referenzspannung und kleiner ist als die fünfte Referenzspannung, der Schalttransistor (Q3) der Schutzschaltung (IC3) so gesteuert wird, dass er sich in einem Leitungszustand befindet.

7. AC-DC-Leistungsumrichtschaltung nach Anspruch 6, **dadurch gekennzeichnet, dass** die Schutzschaltung (IC3) weiter einen dritten Vergleicher (U6), einen vierten Vergleicher (U7), einen fünften Vergleicher (U8), einen zweiten RS-Flipflop (U9) und ein zweites AND-Gatter (U10) umfasst; wobei
der dritte Vergleicher (U6) ausgelegt ist zum Vergleichen der zweiten Abtastspannung mit der vierten Abtastspannung und Ausgeben eines zweiten Vergleichssignals;
der vierte Vergleicher (U7) ausgelegt ist zum Vergleichen der zweiten Abtastspannung mit der dritten Referenzspannung und Ausgeben eines dritten Vergleichssignals;
der fünfte Vergleicher (U8) ausgelegt ist zum Vergleichen der zweiten Abtastspannung mit der fünften Referenzspannung und Ausgeben eines ersten Vergleichssignals;
der zweite RS-Flipflop (U9) ausgelegt ist zum Empfangen des zweiten Vergleichssignals und des dritten Vergleichssignals und Ausgeben eines Zwischenspeichersignals;
das zweite AND-Gatter (U10) ausgelegt ist zum Durchführen einer AND-Logik an dem Zwischenspeichersignal und dem ersten Vergleichssignal und Ausgeben eines Steuersignals des Schalttransistors (Q3) der Schutzschaltung (IC3); und
der Schalttransistor der Schutzschaltung (IC3) ausgelegt ist, sich in einem Leitungs- oder Nichtleitungszustand zu befinden, auf Basis des Steuersignals des Schalttransistors (Q3) der Schutzschaltung (IC3).

8. AC-DC-Leistungsumrichtschaltung nach Anspruch 6, **dadurch gekennzeichnet, dass** die AC-DC-Leistungsumrichtschaltung weiter eine DCDC-Umrichtungsschaltung umfasst, die ausgelegt ist zum Umrichten einer von dem DC-Spannungsausgangsanschluss ausgegebenen höheren DC-Spannung in eine niedrigere DC-Spannung, wobei die DCDC-Umrichtschaltung eine Versorgungsschnittstelle und eine Masseschnittstelle umfasst, die Versorgungsschnittstelle der DCDC-Umrichtschaltung an den DC-Spannungsausgangsanschluss angeschlossen ist und die Masseschnittstelle der DCDC-Umrichtschaltung an den Referenzmasseanschluss angeschlossen ist.

9. AC-DC-Leistungsumrichtschaltung nach Anspruch 6, **dadurch gekennzeichnet, dass** die AC-DC-Leistungsumrichtschaltung weiter eine DCDC-Umrichtschaltung umfasst, die ausgelegt ist zum Umrichten einer von dem DC-Spannungsausgangsanschluss ausgegebenen höheren DC-Spannung in eine niedrigere DC-Spannung, wobei die DCDC-Umrichtschaltung eine Versorgungsschnittstelle und eine Masseschnittstelle umfasst, die Versorgungsschnittstelle der DCDC-Umrichtschaltung an den DC-Spannungsausgangsanschluss angeschlossen ist und die Masseschnittstelle der DCDC-Umrichtschaltung an den gemeinsamen Anschluss des zweiten Kondensators (C2) und des dritten Widerstands (R3) angeschlossen ist.

10. AC-DC-Leistungsumrichtschaltung, **dadurch gekennzeichnet, dass** die AC-DC-Leistungsumrichtschaltung einen positiven AC-Spannungseingangsanschluss, einen negativen AC-Spannungseingangsanschluss, einen DC-Spannungsausgangsanschluss, einen Referenzmasseanschluss, einen ersten Kondensator (C1), einen zweiten Kondensator (C2), einen dritten Kondensator (C3), einen vierten Kondensator (C4), einen Common-Differential-Mode-Induktor, eine dritte Diode (D3), eine vierte Diode (D4) und zwei aktive Diodenschaltungen (IC1, IC2) nach einem der Ansprüche 1-4 umfasst, wobei
der erste Kondensator (C1) zwischen den positiven AC-Spannungseingangsanschluss und den negativen AC-Spannungseingangsanschluss geschaltet ist;
der zweite Kondensator (C2) zwischen den DC-Spannungsausgangsanschluss und den Referenzmasseanschluss geschaltet ist;
der Common-Differential-Mode-Induktor mit einer Primärwicklung und einer Sekundärwicklung versehen ist; ein positiver Anschluss der Primärwicklung mit dem positiven AC-Spannungseingangsanschluss verbunden ist, ein negativer Anschluss der Primärwicklung mit einer Anode der dritten Diode (D) verbunden ist; ein positiver Anschluss der Sekundärwicklung mit dem negativen AC-Spannungseingangsanschluss verbunden ist und ein negativer Anschluss der Sekundärwicklung mit einer Anode der vierten Diode (D4) verbunden ist;
eine Eingangsschnittstelle einer ersten aktiven Diodenschaltung (IC1) mit der Anode der dritten Diode (D3) verbunden ist, eine Masseschnittstelle der ersten aktiven Diodenschaltung (IC1) mit dem Referenzmasseanschluss verbunden ist, eine Leistungsschnittstelle (VCC) der ersten aktiven Diodenschaltung (IC1) durch den dritten Kondensator (C3) mit dem Referenzmasseanschluss verbunden ist und eine Steuerschnittstelle (G) der ersten aktiven Diodenschaltung (IC1) mit dem Referenzmasseanschluss verbunden ist;
eine Eingangsschnittstelle einer zweiten aktiven Diodenschaltung (IC2) mit der Anode der vierten Diode (D4) verbunden ist, eine Masseschnittstelle der zweiten aktiven Diodenschaltung (IC2) mit dem Referenzmasseanschluss verbunden ist, eine Leistungsschnittstelle (VCC) der zweiten aktiven Diodenschaltung (IC2) durch den vierten Kondensator (C3) mit dem Referenzmasseanschluss verbunden ist und eine Steuerschnittstelle (G) der zweiten aktiven Diodenschaltung (IC2) mit dem Referenzmasseanschluss verbunden ist; und
eine Kathode der dritten Diode (D3) und eine Kathode der vierten Diode (D4) mit dem DC-Spannungsausgangsanschluss verbunden sind.

## Revendications

1. Circuit à diode active, le circuit à diode active comprenant une interface d'alimentation (VCC), une interface de drain (D), une interface de commande (G), une interface de source (S), une unité logique (200), une source de courant constant (100) et un premier transistor de commutation (Q1) ; où
la source de courant constant (100) est dotée d'une première borne, d'une deuxième borne, d'une troisième borne et d'une quatrième borne, la première borne étant connectée à l'interface de drain (D) du circuit à diode active, la deuxième borne et la troisième borne étant toutes deux connectées à l'interface d'alimentation (VCC), et la quatrième borne étant connectée à l'unité logique (200) ; et la source de courant constant (100) est configurée pour fournir un courant constant lorsqu'une entrée de tension provenant de l'interface de drain (D) du circuit à diode active charge un condensateur de stockage d'énergie externe à travers l'interface d'alimentation (VCC) ;
l'unité logique (200) est dotée d'une première borne d'entrée, d'une deuxième borne d'entrée et d'une borne de sortie, la première borne d'entrée étant connectée à la quatrième borne de la source de courant constant (100), la deuxième borne d'entrée étant connectée à l'interface de commande (G), et la borne de sortie étant connectée à une électrode de grille du premier transistor de commutation (Q1) ; et l'unité logique (200) est configurée pour :
contrôler si une diode de corps parasite du premier transistor de commutation (Q1) est dans un état de conduction, c'est-à-dire si une différence de tension entre une électrode de source et une électrode de drain du premier transistor de commutation (Q1) est supérieure à une tension de conduction de la diode de corps,
recevoir un signal PWM en provenance de l'interface de commande (G) en tant que signal de commande pour le premier transistor de commutation (Q1), si la diode de corps est dans un état de non-conduction ; et
blinder le signal PWM en provenance de l'interface de commande (G) et délivrer en sortie un signal de niveau électrique pour commander le premier commutateur (Q1) pour qu'il soit dans un état de conduction, si la diode de corps est dans un état de conduction ; et
l'électrode de drain du premier transistor de commutation (Q1) est connectée à l'interface de drain du circuit à diode active, et l'électrode de source du premier transistor de commutation (Q1) est connectée à l'interface de source (S) du circuit à diode active, où la source de courant constant (100) comprend une première diode (D1) et un deuxième transistor de commutation (Q2) ; et le deuxième transistor de commutation (Q2) est pourvu sous la forme d'un transistor MOS de type à déplétion ou d'un transistor JFET, où une électrode de drain du deuxième transistor de commutation (Q2) constitue la première borne de la source de courant constant (100), une électrode de source du deuxième transistor de commutation (Q2) est connectée à une anode de la première diode (D1) et constitue la quatrième borne de la source de courant constant (100), et une électrode de grille du deuxième transistor de commutation (Q2) constitue la deuxième borne de la source de courant constant (100) ; et une cathode de la première diode (D1) constitue la troisième borne de la source de courant constant (100).

2. Circuit à diode active selon la revendication 1, **caractérisé en ce que** l'unité logique (200) comprend un premier comparateur (U4), un deuxième comparateur (U5), une première bascule RS (U1) et une porte OU (U2), et l'interface source (S) du circuit à diode active est connectée à un potentiel de masse ; où :
le premier comparateur (U4) est configuré pour recevoir une tension de drain du premier transistor de commutation (Q1) par l'intermédiaire de la quatrième borne de la source de courant constant (100), et pour comparer la tension de drain du premier transistor de commutation (Q1) à une première tension de référence afin de délivrer en sortie un premier signal ;
le deuxième comparateur (U5) est configuré pour recevoir la tension de drain du premier transistor de commutation (Q1) par l'intermédiaire de la quatrième borne de la source de courant constant (100), et pour comparer la tension de drain du premier transistor de commutation (Q1) à une deuxième tension de référence afin d'délivrer en sortie un deuxième signal ;
la première bascule RS (U1) est configurée pour délivrer en sortie et verrouiller un troisième signal sur la base du premier signal et du deuxième signal ; et
la porte OU (U2) est configurée pour appliquer une logique OU sur le troisième signal et le signal PWM, et pour délivrer en sortie le signal de commande pour le premier transistor de commutation (Q1).

3. Circuit à diode active selon la revendication 3, **caractérisé en ce que** l'unité logique (200) comprend en outre une première porte ET (U3) ; où
la première porte ET (U3) est configurée pour appliquer une logique ET sur un signal NON du troisième signal et du signal PWM, et délivrer en sortie un quatrième signal ; et
la porte OU (U2) est configurée pour appliquer une logique OU sur le troisième signal et le quatrième signal, et délivrer en sortie le signal de commande pour le premier transistor de commutation (Q1).

4. Circuit à diode active selon la revendication 1, **caractérisé en ce que** le circuit à diode active comprend en outre une deuxième diode (D2), où l'anode de la deuxième diode est connectée à l'interface de commande (G), et la cathode de la deuxième diode est connectée à l'interface d'alimentation (VCC).

5. Circuit de conversion de puissance AC-DC, **caractérisé en ce que** le circuit de conversion de puissance AC-DC comprend une borne d'entrée positive de tension AC, une borne d'entrée négative de tension AC, une borne de sortie de tension DC, une borne de masse de référence, un contrôleur PFC, un premier condensateur (C1), un deuxième condensateur (C2), un troisième condensateur (C3), un quatrième condensateur (C4), un inducteur en mode commun-différentiel, une troisième diode (D3), une quatrième diode (D4), et deux circuits de diodes actives (IC1, IC2) selon l'une quelconque des revendications 1 à 4 ; où
le contrôleur PFC est configuré pour délivrer en sortie un signal de commande PFC sur la base d'une tension d'échantillonnage de la borne de sortie de tension continue DC et d'un courant d'échantillonnage de l'inducteur en mode commun-différentiel ;
le premier condensateur (C1) est connecté en série entre la borne d'entrée positive de la tension alternative AC et la borne d'entrée négative de la tension alternative AC ;
le deuxième condensateur (C2) est connecté en série entre la borne de sortie de tension continue DC et la borne de masse de référence ;
l'inducteur en mode commun-différentiel est pourvu d'un enroulement primaire et d'un enroulement secondaire, une borne positive de l'enroulement primaire est connectée à la borne d'entrée positive de la tension alternative AC, une borne négative de l'enroulement primaire est connectée à l'anode de la troisième diode (D3), une borne positive de l'enroulement secondaire est connectée à la borne d'entrée négative de la tension alternative AC, une borne négative de l'enroulement secondaire est connectée à l'anode de la quatrième diode (D4), un inducteur en mode différentiel de l'inducteur en mode commun-différentiel est configurée pour le stockage de l'énergie d'un circuit PFC, et un inducteur en mode commun de l'inducteur en mode commun-différentiel est configuré pour éliminer le bruit en mode commun ;
une interface de drain d'un premier circuit à diode active (IC1) est connectée à l'anode de la troisième diode, une interface de source du premier circuit à diode active (IC1) est connectée à la borne de masse de référence, une interface d'alimentation (VCC) du premier circuit à diode active (IC1) est connectée à la borne de masse de référence à travers le troisième condensateur (C3), et une interface de commande du premier circuit à diode active (IC1) est connectée à une borne de sortie du contrôleur PFC ;
une interface de drain d'un deuxième circuit à diode active (IC2) est connectée à l'anode de la quatrième diode, une interface de source du deuxième circuit à diode active (IC2) est connectée à la borne de masse de référence, une interface d'alimentation (VCC) du deuxième circuit à diode active (IC2) est connectée à la borne de masse de référence par l'intermédiaire du quatrième condensateur (C4), et une interface de commande du deuxième circuit à diode active (IC2) est connectée à la borne de sortie du contrôleur PFC ; et
une cathode de la troisième diode (D3) et une cathode de la quatrième diode (D4) sont connectées à la borne de sortie de la tension continue DC.

6. Circuit de conversion de puissance AC-DC selon la revendication 5, **caractérisé en ce que** le circuit de conversion de puissance AC-DC comprend en outre un circuit de protection (IC3), une première résistance (R1), une deuxième résistance (R2) et une troisième résistance (R3) ; où
la première résistance (R1) et la deuxième résistance (R2), connectées en série entre la borne de sortie de tension continue DC et la borne de masse de référence, sont configurées pour diviser la tension de sortie de la borne de sortie de tension continue afin d'obtenir une deuxième tension d'échantillonnage ;
la troisième résistance (R3) est connectée entre le deuxième condensateur (C2) et la borne de masse de référence ;
le circuit de protection (IC3) comprend une interface d'alimentation (VCC), une interface d'entrée (Vin), une interface de drain (D), une interface de source (S) et un transistor de commutation (Q3) ; l'interface d'alimentation (VCC) du circuit de protection (IC3) est connectée à l'interface d'alimentation (VCC) du premier circuit à diode active (IC1) ou à l'interface d'alimentation (VCC) du deuxième circuit à diode active (IC2), l'interface d'entrée (Vin) du circuit de protection (IC3) est configurée pour recevoir la deuxième tension d'échantillonnage, l'interface de drain (D) du circuit de protection (IC3) est connectée à une borne commune du deuxième condensateur (C2) et de la troisième résistance (R3), et l'interface de source (S) du circuit de protection (IC3) est connectée à la borne de masse de référence ;
une électrode de drain du transistor de commutation (Q3) du circuit de protection (IC3) est connectée à l'interface de drain (D) du circuit de protection (IC3),
et une électrode de source du transistor de commutation (Q3) du circuit de protection (IC3) est connectée à l'interface de source (S) du circuit de protection (IC3) ; et
le circuit de protection (IC3) est configuré pour détecter la deuxième tension d'échantillonnage, lorsque la deuxième tension d'échantillonnage est inférieure à une quatrième tension de référence ou lorsque la deuxième tension d'échantillonnage est supérieure à une cinquième tension de référence, le transistor de commutation (Q3) du circuit de protection (IC3) est commandé pour être dans un état de non-conduction ; et, lorsque la deuxième tension d'échantillonnage est supérieure à une troisième tension de référence et inférieure à la cinquième tension de référence, le transistor de commutation (Q3) du circuit de protection (IC3) est commandé pour être dans un état de conduction.

7. Circuit de conversion de puissance AC-DC selon la revendication 6, **caractérisé en ce que** le circuit de protection (IC3) comprend en outre un troisième comparateur (U6), un quatrième comparateur (U7), un cinquième comparateur (U8), une deuxième bascule RS (U9) et une deuxième porte ET (U10) ; où
le troisième comparateur (U6) est configuré pour comparer la deuxième tension d'échantillonnage à la quatrième tension de référence et délivrer en sortie un deuxième signal de comparaison ;
le quatrième comparateur (U7) est configuré pour comparer la deuxième tension d'échantillonnage à la troisième tension de référence et délivrer en sortie un troisième signal de comparaison ;
le cinquième comparateur (U8) est configuré pour comparer la deuxième tension d'échantillonnage à la cinquième tension de référence et délivrer en sortie un premier signal de comparaison ;
la deuxième bascule RS (U9) est configurée pour recevoir le deuxième signal de comparaison et le troisième signal de comparaison, et délivrer en sortie un signal de verrouillage ;
la deuxième porte ET (U10) est configurée pour appliquer une logique ET sur le signal de verrouillage et le premier signal de comparaison, et délivrer en sortie un signal de commande du transistor de commutation (Q3) du circuit de protection (IC3) ; et
le transistor de commutation du circuit de protection (IC3) est configuré pour être dans un état de conduction ou dans un état de non-conduction sur la base du signal de commande du transistor de commutation (Q3) du circuit de protection (IC3).

8. Circuit de conversion de puissance AC-DC selon la revendication 6, **caractérisé en ce que** le circuit de conversion de puissance AC-DC comprend en outre un circuit de conversion DCDC configuré pour convertir une tension DC supérieure délivrée en sortie par la borne de sortie de tension DC en une tension DC inférieure, où le circuit de conversion DCDC comprend une interface d'alimentation et une interface de masse, l'interface d'alimentation du circuit de conversion DCDC est connectée à la borne de sortie de tension DC, et l'interface de masse du circuit de conversion DCDC est connectée à la borne de masse de référence.

9. Circuit de conversion de puissance AC-DC selon la revendication 6, **caractérisé en ce que** le circuit de conversion de puissance AC-DC comprend en outre un circuit de conversion DCDC configuré pour convertir une tension continue DC supérieure délivrée en sortie par la borne de sortie de tension continue DC en une tension continue DC inférieure, où le circuit de conversion DCDC comprend une interface d'alimentation et une interface de masse, l'interface d'alimentation du circuit de conversion DCDC est connectée à la borne de sortie de tension continue DC, et l'interface de masse du circuit de conversion DCDC est connectée à la borne commune du deuxième condensateur (C2) et de la troisième résistance (R3) .

10. Circuit de conversion de puissance AC-DC, **caractérisé en ce que** le circuit de conversion de puissance AC-DC comprend une borne d'entrée positive de tension alternative AC, une borne d'entrée négative de tension alternative AC, une borne de sortie de tension continue DC, une borne de masse de référence, un premier condensateur (C1), un deuxième condensateur (C2), un troisième condensateur (C3), un quatrième condensateur (C4), un inducteur en mode commun-différentiel, une troisième diode (D3), une quatrième diode (D4), et deux circuits à diode active (IC1, IC2) selon l'une quelconque des revendications 1 à 4 ; où
le premier condensateur (C1) est connecté entre la borne d'entrée positive de la tension alternative AC et la borne d'entrée négative de la tension alternative AC ;
le deuxième condensateur (C2) est connecté entre la borne de sortie de tension continue DC et la borne de masse de référence ;
l'inducteur en mode commun-différentiel est pourvu d'un enroulement primaire et d'un enroulement secondaire ; une borne positive de l'enroulement primaire est connectée à la borne d'entrée positive de la tension alternative AC, une borne négative de l'enroulement primaire est connectée à l'anode de la troisième diode (D) ; une borne positive de l'enroulement secondaire est connectée à la borne d'entrée négative de la tension alternative AC, et une borne négative de l'enroulement secondaire est connectée à l'anode de la quatrième diode (D4) ;
une interface d'entrée d'un premier circuit à diode active (IC1) est connectée à l'anode de la troisième diode (D3), une interface de masse du premier circuit à diode active (IC1) est connectée à la borne de masse de référence, une interface d'alimentation (VCC) du premier circuit à diode active (IC1) est connectée à la borne de masse de référence à travers le troisième condensateur (C3), et une interface de contrôle (G) du premier circuit à diode active (IC1) est connectée à la borne de masse de référence ;
une interface d'entrée d'un deuxième circuit à diode active (IC2) est connectée à l'anode de la quatrième diode (D4), une interface de masse du deuxième circuit à diode active (IC2) est connectée à la borne de masse de référence, une interface d'alimentation (VCC) du deuxième circuit à diode active (IC2) est connectée à la borne de masse de référence par l'intermédiaire du quatrième condensateur (C3), et une interface de commande (G) du deuxième circuit à diode active (IC2) est connectée à la borne de masse de référence ; et
une cathode de la troisième diode (D3) et une cathode de la quatrième diode (D4) sont connectées à la borne de sortie de tension continue DC.
